# EUROPEAN PATENT APPLICATION

(11) **EP 4 787 423 A1**
(43) Date of publication of application: **05.08.2026**
(21) Application number: 24887744.1
(22) Date of filing: 22.10.2024
(51) Int. Cl.: H01L 21/263, H10D 30/47

(54) **ETCHING METHOD FOR SC-CONTAINING LAYER, SEMICONDUCTOR DEVICE AND MANUFACTURING METHOD THEREFOR, AND PROCESS DEVICE**

(30) Priority: 09.11.2023 CN 202311491378
(71) Applicant: Beijing NAURA Microelectronics Equipment Co., Ltd., Beijing 100176 (CN)
(72) Inventor: LIN, Yuanwei, Beijing 100176 (CN); WANG, Jianzong, Beijing 100176 (CN)
(74) Representative: Cohausz & Florack
(86) International application number: PCT/CN2024/126331
(87) International publication number: WO 2025/098131

(57) **Abstract**

The present disclosure relates to the field of semiconductor technology, and in particular, to an etching method for a Sc-containing layer, a semiconductor device and a manufacturing method therefor, and a process equipment. The etching method includes a main etching process step and an auxiliary etching process step, which are performed cyclically; the main etching process step includes introducing process gases into a process chamber, exciting the process gases to generate plasma, and etching the Sc-containing layer; and the auxiliary etching process step includes at least one of a volatilization step or a cooling step. The manufacturing method includes the etching method. The semiconductor device is manufactured with the manufacturing method and has a recessed gate structure formed therein. The process equipment adopts the etching method or the manufacturing method. The etching method can increase an etching rate of the Sc-containing layer.

## Description

### TECHNICAL FIELD

The present disclosure relates to the field of semiconductor technology, and in particular, to an etching method for a Sc-containing layer, a semiconductor device and a manufacturing method therefor, and a process equipment.

### BACKGROUND

Modern communication has moved into the 5G era, and proposes higher and higher requirements on operating frequency of semiconductor devices in the future development to 6G. An operating frequency of a semiconductor device can be increased by increasing carrier mobility in a channel. Specifically, a high-electron-mobility semiconductor device manufactured based on a high-mobility two-dimensional electron gas may be selected, and in the semiconductor device, metals of materials in the two-dimensional electron gas system are generally group IIIA elements (e.g., Al, Ga, and In), or group IIIB metal elements (e.g., Sc) with a predominant valence state of +3.

An ionic radius of Sc is between that of Ga and that of In, and Sc has good capability of forming Sc-containing alloy with group III-V compounds such as AlN and GaN, the Sc-containing alloy such formed has relatively high piezoelectric coefficient and spontaneous polarization, and a channel in a semiconductor device made of the Sc-containing alloy has high surface charge density and electron mobility. However, in a dry etching process of the Sc alloy, since a generated by-product ScCl₃ has a significant high boiling point than other metal halides, ScCl₃ is hard to volatilize from a reaction system; and content of Sc can affect an etching rate, the higher the content, the more difficult the dry etching. There is no effective rapid etching method for a Sc-containing alloy layer in the existing technology, which limits application and popularization of the Sc-containing alloy in the semiconductor devices.

### SUMMARY

The present disclosure aims to provide an etching method for a Sc-containing layer, a semiconductor device and a manufacturing method therefor, and a process equipment, so as to solve the technical problem of the low etching rate during etching of the Sc-containing alloy layer.

An embodiment of the present disclosure provides an etching method for a Sc-containing layer, including a main etching process step and an auxiliary etching process step, which are cyclically performed; wherein
the main etching process step includes: introducing process gases into a process chamber, exciting the process gases to generate plasma, and etching the Sc-containing layer, the process gases including a chlorine-containing gas and an inert gas;
the auxiliary etching process step includes: at least one of a volatilization step or a cooling step;
the volatilization step includes: reducing a lower electrode power to zero or near zero, and decreasing flow rates of the process gases to zero or near zero; and
the cooling step includes: reducing the lower electrode power to zero or near zero, decreasing a flow rate of the chlorine-containing gas to zero or near zero, and continuously introducing the inert gas.

In some embodiments, the main etching process step includes a first etching step and/or a second etching step, the process gases used at the first etching step are the same as the process gases used at the second etching step, and the lower electrode power at the first etching step is higher than the lower electrode power at the second etching step.

In some embodiments, a lower electrode power ratio of the first etching step to the second etching step is (1.2-1.8):1; and/or
a process time ratio of the first etching step to the second etching step is 1:(4-6).

In some embodiments, the lower electrode power at the first etching step is 100 W to 1000 W; and the lower electrode power at the second etching step is 100 W to 1000 W; and/or
a process time of the first etching step is 1.2 s to 3 s, and a process time of the second etching step is 8 s to 12 s.

In some embodiments, at the main etching process step, a flow ratio of the chlorine-containing gas to the inert gas is (0.3-0.5):1; and/or
at the main etching process step, the flow rate of the chlorine-containing gas is 20 sccm to 200 sccm, and a flow rate of the inert gas is 10 sccm to 1000 sccm.

In some embodiments, the chlorine-containing gas includes at least one of SiCl₄, BCl₃ or Cl₂, and/or the inert gas includes Ar.

In some embodiments, the chlorine-containing gas includes BCl₃ and Cl₂, and a flow ratio of BCl₃ to Cl₂ is (0.9-1.1):1; or
the chlorine-containing gas includes SiCl₄.

In some embodiments, a process time of the volatilization step is 0.5 s to 1.5 s; and/or a process time of the cooling step is 0.5 s to 1.5 s.

Compared with the existing technology, the etching method for a Sc-containing layer provided in the embodiment of the present disclosure has the following beneficial effects.

In the embodiment of the present disclosure, at the main etching process step, the process gases such as the chlorine-containing gas and the inert gas are introduced into the process chamber and excited to generate the plasma, and the Sc-containing layer is effectively etched; and at the auxiliary etching process step, the lower electrode power is reduced to zero or near zero. When the flow rates of the process gases are reduced to zero or near zero, etching by-products can easily volatilize quickly during vacuum pumping. When the flow rate of the chlorine-containing gas is reduced to zero or near zero and the inert gas is continuously introduced, at least part of the etching by-products can easily volatilize quickly during vacuum pumping, and heat of the Sc-containing layer can also be taken away, which ensures etching uniformity. By cyclically performing the main etching process step and the auxiliary etching process step, the etching by-products generated at each cyclic step can volatilize in time, so that an influence on etching depth and etching quality at a subsequent cyclic step can be alleviated or even avoided, which ensures the etching depth and the etching quality (such as etching uniformity) at each cyclic step, and improves an etching rate of the Sc-containing layer, that is, realizing rapid etching of the Sc-containing layer.

An embodiment of the present disclosure further provides a manufacturing method for a semiconductor device, including:
providing a substrate;
forming a Sc-containing layer on the substrate;
etching the Sc-containing layer with the above etching method to form a recess with a preset depth, the preset depth being smaller than a thickness of the Sc-containing layer; and
forming a gate in the recess, and forming a source and a drain on two sides of the recess.

The adoption of the etching method for a Sc-containing layer provided in the embodiment of the present disclosure can produce the same beneficial effects as the above etching method, that is, etching efficiency can be improved, which will not be described here.

An embodiment of the present disclosure further provides a semiconductor process equipment, including a process chamber, a gas inlet assembly, an upper electrode assembly, a lower electrode assembly, and a controller, the controller includes at least one processor and at least one storage device, and the at least one storage device has stored therein a computer program which, when executed by the at least one processor, implements the above etching method or the above manufacturing method.

The process equipment provided in the embodiment of the present disclosure has the beneficial effects of the etching method and the manufacturing method, which will not be described here.

An embodiment of the present disclosure further provides a semiconductor device, including:
a substrate;
a Sc-containing layer, which is disposed on the substrate, a recess being formed in the Sc-containing layer on a side away from the substrate, and having a depth smaller than a thickness of the Sc-containing layer;
a source, which is disposed on a first side of the recess;
a drain, which is disposed on a second side of the recess, the second side being opposite to the first side, and a distance between the source and an edge of the recess on the first side being smaller than a distance between the drain and an edge of the recess on the second side; and
a gate, which is disposed in the recess, a distance between the gate and the source being smaller than a distance between the gate and the drain.

In some embodiments, the Sc-containing layer contains ScₓAl₁₋ₓN, and a value of x is less than 43%; or
a distance between a bottom of the recess and a side of the Sc-containing layer facing the substrate is 1 nm to 100 nm; or
the distance between the source and the edge of the recess on the first side is 0.1 µm to 0.5 µm; or
the distance between the drain and the edge of the recess on the second side is 0.5 µm to 5 µm; or
a length of the gate is 0.5 µm to 5 µm, and a width of the gate is 0.1 mm to 10 mm.

In the semiconductor device provided in the embodiment of the present disclosure, the Sc-containing layer serves as a barrier layer, and the formation of the recess can enable thinning of the barrier layer where the gate is located. With such configuration, when a gate voltage is applied to the gate for regulation, a potential well is formed, and a two-dimensional electron gas is generated, so that high electron mobility in the semiconductor device can be realized; when no gate voltage is applied, the potential well for the two-dimensional electron gas disappears, and the semiconductor device is in an off state, that is, the semiconductor device becomes a normally-off semiconductor device, so that safety control performance of the semiconductor device can be realized.

### BRIEF DESCRIPTION OF DRAWINGS

In order to describe the technical solutions in the embodiments of the present disclosure or the existing technology more clearly, the drawings for the description of the embodiments or the existing technology will be briefly described below. Apparently, the drawings described below are just for the embodiments of the present disclosure, and other drawings can be derived by those of ordinary skill in the art from the drawings provided herein without any inventive work.
FIG. 1 is a schematic cross-sectional view of a semiconductor device including a Sc-containing layer according to an embodiment of the present disclosure;
FIG. 2a to FIG. 2n are flowcharts illustrating a manufacturing method for a semiconductor device including a Sc-containing layer according to an embodiment of the present disclosure;
FIG. 3a is a result characterization diagram of etching of ScₓAl₁₋ₓN according to an embodiment of the present disclosure;
FIG. 3b is an enlarged view of a portion L of FIG. 3a;
FIG. 3c and FIG. 3d are enlarged views of a portion R of FIG. 3a;
FIG. 4a to FIG. 4d are enlarged views of a portion M of FIG. 3a, which differ in etching thickness of ScₓAl₁₋ₓN;
FIG. 5a to FIG. 5d are result characterization diagrams of etching of ScₓAl₁₋ₓN according to a first comparative example;
FIG. 6a and FIG. 6b are EDX characterization diagrams of by-products generated by etching of ScₓAl₁₋ₓN according to the first comparative example;
FIG. 7 is a statistical chart of etching results according to a second comparative example;
FIG. 8a and FIG. 8b are characterization diagrams of an etching result according to a third comparative example;
FIG. 9a to FIG. 9d are characterization diagrams of an etching result according to a fourth comparative example;
FIG. 10 is a schematic structural diagram of a semiconductor process equipment according to an embodiment of the present disclosure; and
FIG. 11a and FIG. 11b are schematic diagrams of energy levels in the semiconductor device of FIG. 1.

### Description of reference numerals:

100-epitaxial wafer; 110-epitaxial layer; 120-substrate; 130-buffer layer;
200-barrier layer; 210-source; 220-gate; 230-drain; 240-recesss;
310-first photoresist layer; 311-first opening;
320-second photoresist layer; 321-second opening; 322-third opening;
330-third photoresist layer; 331-fourth opening;
400-passivation layer;
500-process chamber; 510-upper electrode assembly; 520-lower electrode assembly;
511-radio frequency coil; 512-upper radio frequency power supply; 513-upper matcher;
521-wafer carrier; 522-lower radio frequency power supply; 523-lower matcher.

### DETAIL DESCRIPTION OF EMBODIMENTS

The technical solutions in the present disclosure are clearly and thoroughly described below with reference to the drawings. Apparently, the embodiments described herein are just some embodiments of the present disclosure, and do not cover all embodiments. All other embodiments derived by those of ordinary skill in the art from the embodiments described herein without inventive work fall within the scope of the present disclosure.

Sc is a group IIIB metal element with a predominant valence state of +3, the ionic radius of Sc is between that of Ga and that of In, and Sc has good capability of forming alloy (such as ScₓAl₁₋ₓN) with III-V compounds such as AlN and GaN. A Sc-containing layer (e.g., a ScₓAl₁₋ₓN layer) has high piezoelectric coefficient and spontaneous polarization, and a channel in a semiconductor device including the Sc-containing layer can have high surface charge density (for example, mobility of a High Electron Mobility Transistor (HEMT) using a ScₓAl₁₋ₓN barrier layer is about 5 times that of an HEMT using an AlₓGa₁₋ₓN barrier layer), so that mobility of the semiconductor device can be improved. In the dry etching process of the Sc-containing layer, Sc and Cl react to generate the by-product ScCl₃, and the by-product is attached to a sidewall of an etching hole and is hard to volatilize, which affects an etching rate of the Sc-containing layer; moreover, an angle for etching the Sc-containing layer cannot be kept consistent with an angle for etching photoresist, which affects etching uniformity and etching quality.

The embodiments of the present disclosure provide an etching method for a Sc-containing layer, a semiconductor device, a manufacturing method thereof, and a process equipment, which can improve etching rate and etching quality during an etching process, and can substantially keep an angle of the Sc-containing layer consistent with an angle of photoresist. The present disclosure is further illustrated in detail below by exemplary embodiments with reference to the drawings.

### First Embodiment

An embodiment of the present disclosure provides an etching method for a Sc-containing layer, including a main etching process step and an auxiliary etching process step, which are cyclically performed.

The main etching process step includes: introducing process gases into a process chamber, exciting the process gases to generate plasma, and etching the Sc-containing layer, with the process gases including a chlorine-containing gas and an inert gas.

The auxiliary etching process step includes: at least one of a volatilization step or a cooling step.

The volatilization step includes: reducing a lower electrode power to zero or near zero, and decreasing flow rates of the process gases to zero or near zero.

The cooling step includes: reducing the lower electrode power to zero or near zero, decreasing a flow rate of the chlorine-containing gas to zero or near zero, and continuously introducing the inert gas.

In the embodiment of the present disclosure, at the main etching process step, the process gases such as the chlorine-containing gas and the inert gas are introduced into the process chamber and excited to generate the plasma, and the Sc-containing layer is etched; and at the auxiliary etching process step, the lower electrode power is reduced to zero or near zero. When the flow rates of the process gases are reduced to zero or near zero, by-products generated in the etching process can easily volatilize quickly during vacuum pumping (only the by-products can be pumped away due to no introduction of other gases). When the flow rate of the chlorine-containing gas is reduced to zero or near zero and the inert gas is continuously introduced, at least part of the by-products generated in the etching process can easily volatilize quickly during vacuum pumping, and heat of the Sc-containing layer can also be taken away, which ensures etching uniformity. By cyclically performing the main etching process step and the auxiliary etching process step, the by-products generated at each cyclic step can volatilize in time, so that an influence on etching depth and etching quality at a subsequent cyclic step can be alleviated or even avoided, which ensures the etching depth and the etching quality (such as etching uniformity) at each cyclic step, and improves etching rate and etching uniformity of the Sc-containing layer, that is, realizing rapid etching of the Sc-containing layer.

It should be noted that in the above volatilization step and cooling step, "reducing" refers to turning off the lower electrode power or setting the lower electrode power to a small value or a value close to zero; and "decreasing" refers to stopping introduction of the process gases or the chlorine-containing gas, or setting the flow rates of the process gases or the flow rate of the chlorine-containing gas to a small value or a value close to zero.

In the embodiment of the present disclosure, the main etching process step includes at least one of a first etching step or a second etching step, the process gases used at the first etching step are the same as those used at the second etching step, and the lower electrode power at the first etching step is higher than that at the second etching step. With such configuration, at the first etching step, some chemical bonds can be broken during the process for facilitating etching at the subsequent second etching step, and a large amount of heat can be generated, thereby facilitating volatilization of the by-products.

In an embodiment of the present disclosure, a lower electrode power ratio of the first etching step to the second etching step may be (1.2-1.8):1, such as (1.3-1.7):1, or (1.4-1.6):1, and may be 1.5:1. By matching the lower electrode power in such way, etching efficiency and etching quality in the corresponding etching process can be ensured, and timely volatilization of the by-products can be facilitated.

In an embodiment of the present disclosure, the lower electrode power at the first etching step is 100 W to 1000 W, such as 300 W to 800 W, or 500 W to 700 W, and may be 600 W; and the lower electrode power of the second etching step is 100 W to 1000 W, such as 200 W to 800 W, or 300 W to 500 W, and may be 400 W. With such configuration of the lower electrode power, the etching efficiency and the etching quality in the corresponding etching process can be ensured, and the timely volatilization of the by-products can be facilitated.

In an embodiment of the present disclosure, a process time ratio of the first etching step to the second etching step is 1:(4-6), and may be 1:5. By matching the process time in such way, the etching efficiency and the etching quality in the corresponding etching process can be ensured.

In an embodiment of the present disclosure, a process time of the first etching step is 1.2 s to 3 s, such as 1.5 s to 2.5 s, and may be 2 s; and a process time of the second etching step is 8 s to 12 s, such as 9 s to 11 s, and may be 10 s. With such configuration of the process time, the etching efficiency and the etching quality in the corresponding etching process can be ensured.

In an embodiment of the present disclosure, at the main etching process step, a flow ratio of the chlorine-containing gas to the inert gas is (0.3-0.5):1, such as (0.35-0.45):1, and may be 0.4:1. By matching the chlorine-containing gas with the inert gas in such way, the etching efficiency and the etching quality in the corresponding etching process can be ensured.

In an embodiment, at the main etching process step, the flow rate of the chlorine-containing gas is 20 sccm to 200 sccm, such as 25 sccm to 150 sccm, or 30 sccm to 100 sccm, or 35 sccm to 70 sccm, and may be 40 sccm; and a flow rate of the inert gas is 10 sccm to 1000 sccm, such as 30 sccm to 800 sccm, or 50 sccm to 500 sccm, or 80 sccm to 200 sccm, and may be 100 sccm. With such configuration of the flow rates of the chlorine-containing gas and the inert gas, the etching efficiency and the etching quality in the corresponding etching process can be ensured.

In an embodiment of the present disclosure, at the main etching process step, the chlorine-containing gas includes at least one of SiCl₄, BCl₃ or Cl₂. For example, the chlorine-containing gas includes BCl₃ and Cl₂, and a flow ratio of BCl₃ to Cl₂ is (0.9-1.1):1, such as (0.99-1.05):1, and may be 1:1; or the chlorine-containing gas includes SiCl₄. BCl₃ and SiCl₄ can perform both an etching function and a sidewall protection function, and Cl₂ can only perform an etching function. Therefore, when the chlorine-containing gases (such as BCl₃ and SiCl₄) having sidewall protection performance are selected, sidewall protection can be achieved during the etching process, so that anisotropic etching can be realized, and angle consistency of the Sc-containing layer and photoresist during the etching process can be ensured. When Cl₂ is selected, the etching rate can be accelerated and ensured, and a deposition amount of sidewall deposits can be reduced, which facilitates a subsequent cleaning process; moreover, consistency of etching angles of the Sc-containing layer and the photoresist during the etching process can be ensured. In view of the above, for the selection of the process gases, the chlorine-containing gas with the sidewall protection performance and Cl₂ capable of ensuring a high etching rate are preferred, so as to ensure both the etching efficiency and the consistency of the etching angles, thereby ensuring the etching uniformity and the etching quality.

In an embodiment of the present disclosure, at the main etching process step, the inert gas includes Ar. The selection of Ar as the inert gas can ensure the etching efficiency and the etching quality in the corresponding etching process.

In an embodiment of the present disclosure, a process time of the volatilization step is 0.5 s to 1.5 s, such as 0.8 s to 1.2 s, and may be 1 s. With such configuration, the purpose of setting the relatively short process time (such as 1 s or 2 s) for the volatilization step is to reduce total process time without affecting the etching quality so as to increase the etching rate.

In an embodiment of the present disclosure, a process time of the cooling step is 0.5 s to 1.5 s, such as 0.8 s to 1.2 s, and may be 1 s. With such configuration, the purpose of setting the relatively short process time (such as 1 s or 2 s) for the cooling step is to reduce the total process time without affecting the etching quality so as to increase the etching rate. However, the process time cannot be too short, otherwise an effect of the step cannot be produced. In case of longer process time, the volatilization step and the cooling step can produce better effects, but productivity may be affected. In an example of the present disclosure, the process time of the volatilization step and that of the cooling step are set to 1 s.

At the volatilization step, the lower electrode power may be turned off, and the introduction of all the process gases may be stopped, so as to facilitate rapid volatilization of the by-products under the action of vacuum pumping; or the lower electrode power at the volatilization step may be set to a relatively small value or even reduced to a value close to zero, such as 1 W. The flow rates of the process gases at the volatilization step may be set to relatively small values or even decreased to values close to zero, for example, the gas flow rate of the chlorine-containing gas and that of Ar are both set to 1 sccm. With such configuration, on the one hand, the by-products can still volatilize in time; and on the other hand, during rapid switching between the process steps, radio frequency does not need to be turned on or turned off, and gas pipeline valves do not need to be opened or closed, so that frequent on/off of the radio frequency and frequent opening/closing of the gas pipeline valves can be avoided.

At the cooling step, the lower electrode power may be turned off, and Ar may be introduced at a relatively low flow rate, so as to facilitate timely cooling of a wafer to be etched and timely volatilization of at least part of the by-products under the action of vacuum pumping; or the lower electrode power at the cooling step may be set to a relatively small value or even reduced to a value close to zero, such as 1 W. The flow rate of the chlorine-containing gas at the cooling step may be decreased to a value close to zero such as 1 sccm, and Ar is continuously introduced at a relatively low gas flow rate such as 10 sccm. With such configuration, on the one hand, the wafer to be etched can still be cooled in time, and at least part of the by-products can volatilize in time; and on the other hand, during rapid switching between the process steps, the radio frequency does not need to be turned on or turned off, and the gas pipeline valves do not need to be opened or closed, so that frequent on/off of the radio frequency and frequent opening/closing of the gas pipeline valves can be avoided.

In an embodiment of the present disclosure, the etching method may further include a stabilization step and an ignition step before cyclically performing the main etching process step and the auxiliary etching process step, and may further include a desorption step after cyclically performing the main etching process step and the auxiliary etching process step. Process parameters at each step are as described in the following example.

In an embodiment of the present disclosure, the etching method mainly includes the main etching process step and the auxiliary etching process step, the main etching process step includes at least one of the first etching step or the second etching step, and the auxiliary etching process step includes at least one of the volatilization step or the cooling step. The present disclosure is illustrated in detail below by taking a case where the main etching process step includes the first etching step and the second etching step and the auxiliary etching process step includes the volatilization step and the cooling step as an example.

In an example of the present disclosure, the etching method includes the following steps.

S1100, the stabilization step.

During the process of the stabilization step, a chamber pressure is 1 mTorr to 30 mTorr, such as 3 mTorr to 10 mTorr, and may be 5 mTorr; an upper electrode power is 0, the lower electrode power is 0, and the flow rate of Ar is 10 sccm to 1000 sccm, such as 30 sccm to 800 sccm, or 50 sccm to 500 sccm, or 80 sccm to 200 sccm, and may be 100 sccm; the flow rate of the chlorine-containing gas is 20 sccm to 200 sccm, such as 25 sccm to 150 sccm, or 30 sccm to 100 sccm, or 35 sccm to 70 sccm, and may be 40 sccm; and a process time is 2 s to 8 s, such as 4 s to 6 s, and may be 5 s.

S1200, the ignition step.

During the process of the ignition step, the chamber pressure is 1 mTorr to 30 mTorr, such as 3 mTorr to 10 mTorr, and may be 5 mTorr; an upper-electrode center power is 100 W to 1000 W, such as 300 W to 800 W, and may be 600 W; an upper-electrode edge power is 500 W to 1500 W, such as 700 W to 1300 W, or 800 W to 1200 W, or 900 W to 1000 W, and may be 1000 W; the lower electrode power is 0, and the flow rate of Ar is 10 sccm to 1000 sccm, such as 30 sccm to 800 sccm, or 50 sccm to 500 sccm, or 80 sccm to 200 sccm, and may be 100 sccm; the flow rate of the chlorine-containing gas is 20 sccm to 200 sccm, such as 25 sccm to 150 sccm, or 30 sccm to 100 sccm, or 35 sccm to 70 sccm, and may be 40 sccm; and a process time is 2 s to 8 s, such as 4 s to 6 s, and may be 5 s.

S1310, the first etching step.

During the process of the first etching step, the lower electrode power is 100 W to 1000 W, such as 300 W to 800 W, or 500 W to 700 W, and may be 600 W. With such configuration, the etching efficiency and the etching quality can be ensured. Since the lower electrode power is relatively high, some chemical bonds can be broken during the process for facilitating subsequent etching, and a large amount of heat can be generated, which facilitates the volatilization of the by-products.

During the process of the first etching step, the flow rate of Ar is 10 sccm to 1000 sccm, such as 30 sccm to 800 sccm, or 50 sccm to 500 sccm, or 80 sccm to 200 sccm, and may be 100 sccm; and the flow rate of the chlorine-containing gas is 20 sccm to 200 sccm, such as 25 sccm to 150 sccm, or 30 sccm to 100 sccm, or 35 sccm to 70 sccm, and may be 40 sccm. With such configuration of the flow rates of the chlorine-containing gas and the inert gas, the etching efficiency and the etching quality can be ensured.

During the process of the first etching step, the process time is 1 s to 5 s, such as 1.5 s to 3 s, and may be 2 s. With such configuration, the etching efficiency and the etching quality can be ensured.

In addition, during the process of the first etching step, the chamber pressure is 1 mTorr to 30 mTorr, such as 3 mTorr to 10 mTorr, and may be 5 mTorr; the upper-electrode center power is 100 W to 1000 W, such as 300 W to 800 W, and may be 600 W; and the upper-electrode edge power is 500 W to 3000 W, such as 1000 W to 2000 W, and may be 1500 W.

S1320, the second etching step.

During the process of the second etching step, the lower electrode power is 100 W to 1000 W, such as 200 W to 800 W, or 300 W to 500 W, and may be 400 W. With such configuration, the etching efficiency and the etching quality can be ensured.

During the process of the second etching step, the flow rate of Ar is 10 sccm to 1000 sccm, such as 30 sccm to 800 sccm, or 50 sccm to 500 sccm, or 80 sccm to 200 sccm, and may be 100 sccm; and the flow rate of the chlorine-containing gas is 20 sccm to 200 sccm, such as 25 sccm to 150 sccm, or 30 sccm to 100 sccm, or 35 sccm to 70 sccm, and may be 40 sccm. With such configuration of the flow rates of the chlorine-containing gas and the inert gas, the etching efficiency and the etching quality can be ensured.

During the process of the second etching step, the process time is 5 s to 15 s, such as 8 s to 12 s, and may be 10 s. With such configuration, the etching efficiency and the etching quality can be ensured.

In addition, during the process of the second etching step, the chamber pressure is 1 mTorr to 30 mTorr, and may be 5 mTorr; the upper-electrode center power is 100 W to 1000 W, such as 300 W to 800 W, and may be 600 W; and the upper-electrode edge power is 500 W to 3000 W, such as 1000 W to 2000 W, and may be 1500 W.

S1330, the volatilization step.

During the process of the volatilization step, the lower electrode power is 0.5W to 5W, such as 0.8W to 2W, and may be 1 W; the flow rate of Ar is 0.5 sccm to 5 sccm, such as 0.8 sccm to 2 sccm, and may be 1 sccm; and the flow rate of the chlorine-containing gas is 0.5 sccm to 5 sccm, such as 0.8 sccm to 8 sccm, and may be 1 sccm. With such configuration, on the one hand, the by-products can volatilize in time; and on the other hand, during rapid switching between the process steps, the radio frequency does not need to be turned on or turned off, and the gas pipeline valves do not need to be opened or closed, so that frequent on/off of the radio frequency and frequent opening/closing of the gas pipeline valves can be avoided.

During the process of the volatilization step, the process time is 0.5 s to 1.5 s, such as 0.8 s to 1.2 s, and may be 1 s. With such configuration, the total process time can be reduced without affecting the etching quality, thereby increasing the etching rate.

In addition, during the process of the volatilization step, the chamber pressure is 1 mTorr to 30 mTorr, and may be 5 mTorr; the upper-electrode center power is 100 W to 1000 W, such as 300 W to 800 W, and may be 600 W; and the upper-electrode edge power is 500 W to 3000 W, such as 1000 W to 2000 W, and may be 1500 W.

S1340, the cooling step.

During the process of the cooling step, the lower electrode power is 0.5 W to 5 W, such as 0.8 W to 2 W, and may be 1 W; the flow rate of Ar is 1 sccm to 15 sccm, such as 8 sccm to 12 sccm, and may be 10 sccm; and the flow rate of the chlorine-containing gas is 0.5 sccm to 5 sccm, such as 0.8 sccm to 8 sccm, and may be 1 sccm. On the one hand, the wafer to be etched can still be cooled in time, and at least part of the by-products can volatilize in time; and on the other hand, during rapid switching between the process steps, the radio frequency does not need to be turned on or turned off, and the gas pipeline valves do not need to be opened or closed, so that frequent on/off of the radio frequency and frequent opening/closing of the gas pipeline valves can be avoided.

During the process of the cooling step, the process time is 0.5 s to 1.5 s, such as 0.8 s to 1.2 s, and may be 1 s. With such configuration, the total process time can be reduced without affecting the etching quality, thereby increasing the etching rate.

In addition, during the process of the cooling step, the chamber pressure is 1 mTorr to 30 mTorr, such as 3 mTorr to 10 mTorr, and may be 5 mTorr; the upper-electrode center power is 100 W to 1000 W, such as 300 W to 800 W, and may be 600 W; and the upper-electrode edge power is 500 W to 3000 W, such as 1000 W to 2000 W, and may be 1500 W.

S1400, the desorption step.

During the process of the desorption step, the chamber pressure is 10 mTorr to 100 mTorr, such as 30 mTorr to 70 mTorr, and may be 50 mTorr; the upper-electrode center power is 100 W to 1000 W, such as 300 W to 700 W, or 400 W to 600 W, and may be 500 W; the upper-electrode edge power is 100 W to 1000 W, such as 300 W to 700 W, or 400 W to 600 W, and may be 500 W; the lower electrode power is 0; the chlorine-containing gas includes chlorine, the flow rate of chlorine is 10 sccm to 1000 sccm, such as 20 sccm to 500 sccm, or 50 sccm to 200 sccm, and may be 100 sccm; the flow rate of Ar is 10 sccm to 1000 sccm, such as 50 sccm to 600 sccm, or 100 sccm to 300 sccm, and may be 200 sccm; and a process time is 2 s to 8 s, such as 4 s to 6 s, and may be 5 s.

In an example of the present disclosure, the chlorine-containing gas at the stabilization step, the ignition step, the first etching step, and the second etching step includes BCl₃ and Cl₂, the flow rate of BCl₃ is 10 sccm to 100 sccm, such as 15 sccm to 50 sccm, and may be 20 sccm; and the flow rate of Cl₂ is 10 sccm to 100 sccm, such as 15 sccm to 50 sccm, and may be 20 sccm. In addition, the chlorine-containing gases BCl₃ and Cl₂ may be replaced with the chlorine-containing gas SiCl₄, and the flow rate of SiCl₄ is 10 sccm to 100 sccm, such as 15 sccm to 50 sccm, and may be 20 sccm.

In addition, in an example of the present disclosure, a coolant temperature of a base is -15°C to 60°C, such as 0°C to 50°C, and may be 40°C.

In order to illustrate the etching method in the above example of the present disclosure more clearly in details, the process parameters at each process step are shown in the following tables of Table 1 and Table 2.

**Table 1 plasma etching process recipe in the example of the present disclosure**

| process step | chamber pressure/ mTorr | upper-electrode center power/W | upper-electrode edge power/W | lower electrode power/W | flow rate of BCl₃/ sccm | flow rate of Cl₂/ sccm | flow rate of Ar/ sccm | process time/s |
|---|---|---|---|---|---|---|---|---|
| stabilization step | 5 | 0 | 0 | 0 | 20 | 20 | 100 | 5 |
| ignition step | 5 | 600 | 1000 | 0 | 20 | 20 | 100 | 5 |
| cyclic execution of main etching process step and auxiliary etching process step | see Table 2 | see Table 2 | see Table 2 | see Table 2 | see Table 2 | see Table 2 | see Table 2 | see Table 2 |
| desorption step | 50 | 500 | 500 | 0 | 0 | 100 | 200 | 5 |

**Table 2 process recipes of main etching process step and auxiliary etching process step in the example of the present disclosure**

| process step | chamber pressure/ mTorr | upper-electrode center power/W | upper-electrode edge power/W | lower electrode power/W | flow rate of BCl₃/ sccm | flow rate of Cl₂/ sccm | flow rate of Ar/ sccm | process time/s |
|---|---|---|---|---|---|---|---|---|
| first etching step | 5 | 600 | 1500 | 600 | 20 | 20 | 100 | 2 |
| second etching step | 5 | 600 | 1500 | 400 | 20 | 20 | 100 | 10 |
| volatilization step | 5 | 600 | 1500 | 1 | 1 | 1 | 1 | 1 |
| cooling step | 50 | 600 | 1500 | 1 | 1 | 1 | 10 | 1 |

During the above cyclic execution of the main etching process step and the auxiliary etching process step, at least one of the first etching step or the second etching step is selected, and at least one of the volatilization step or the cooling step is selected. For example, the first etching step and the cooling step may be cyclically performed, the second etching step and the cooling step may be cyclically performed, the first etching step and the volatilization step may be cyclically performed, the second etching step and the volatilization step may be cyclically performed, the first etching step, the volatilization step, and the cooling step may be cyclically performed, the second etching step, the volatilization step, and the cooling step may be cyclically performed, the first etching step, the second etching step, and the cooling step may be cyclically performed, or the first etching step, the second etching step, and the volatilization step may be cyclically performed; or all the steps are selected, that is, the first etching step, the second etching step, the volatilization step, and the cooling step are cyclically performed (as shown in Table 2, the main etching process step includes the first etching step and the second etching step, and the auxiliary etching process step includes the volatilization step and the cooling step). BCl₃ and the Cl₂ may also be replaced with other chlorine-containing gases such as SiCl₄. BCl₃ and SiCl₄ can perform both the etching function and the sidewall protection function, but Cl₂ can only perform the etching function. Therefore, when the chlorine-containing gases (such as BCl₃ and SiCl₄) having the sidewall protection performance are selected, sidewall protection can be achieved during the etching process, so that the anisotropic etching can be realized, and the angle consistency of the Sc-containing layer and the photoresist during the etching process can be ensured. When Cl₂ is selected, the etching rate can be accelerated and ensured, and the deposition amount of the sidewall deposits can be reduced, which facilitates the subsequent cleaning process; moreover, the consistency of the etching angles of the Sc-containing layer and the photoresist during the etching process can be ensured. In view of the above, for the selection of the process gases, the chlorine-containing gas with the sidewall protection performance and Cl₂ capable of ensuring a high etching rate are preferred, so as to ensure both the etching efficiency and the consistency of the etching angles, thereby ensuring the etching uniformity and the etching quality.

In the example of the present disclosure, the lower electrode power at the first etching step needs to be significantly higher than that at the second etching step, the lower electrode power at the volatilization step and that at the cooling step need to be as low as possible, the gas flow rates (including the flow rate of the chlorine-containing gas and that of the inert gas) at the volatilization step need to be as low as possible, the gas flow rate of the chlorine-containing gas at the cooling step needs to be as low as possible, and the inert gas needs to be appropriately kept at a certain low gas flow rate at the cooling step for better cooling of the wafer to be etched.

The purpose of setting the parameter values of the lower electrode power, the flow rate of the chlorine-containing gas, and the flow rate of Ar to 1 at the volatilization step is to avoid frequent on/off of the radio frequency and frequent opening/closing of the gas pipeline valves during rapid switching to the volatilization step. The purpose of setting the parameter values of the lower electrode power and the flow rate of the chlorine-containing gas to 1 and setting the parameter value of the flow rate of Ar to 10 (that is, a small amount of inert gas such as Ar is continuously introduced) at the cooling step is to avoid frequent on/off of the radio frequency and frequent opening/closing of the gas pipeline valves during rapid switching to the cooling step, and to ensure a cooling effect of the wafer to be etched. The purpose of setting the relatively short process time (such as 1 s or 2 s) is to reduce the process time without affecting the etching quality so as to increase the etching rate. However, the process time cannot be too short, otherwise the effects of the steps cannot be produced. In case of longer process time, the volatilization step and the cooling step can produce better effects, but the productivity may be affected. In the example of the present disclosure, the process time of the volatilization step and that of the cooling step are set to 1 s.

The lower electrode power at the first etching step is set higher than that at the second etching step, so that some chemical bonds can be broken during the process at the first etching step for facilitating subsequent etching, and a large amount of heat can be generated, which facilitates the volatilization of the by-products. At the volatilization step, the lower electrode power is turned off, the introduction of all the gases is stropped, and vacuum pumping is performed, so that the by-products can volatilize quickly under the action of vacuum pumping (only the by-products can be pumped away due to no introduction of other gases). At the cooling step, the lower electrode power is turned off, the introduction of most of the gases participating in chemical reactions is stropped (only the inert gas Ar is continuously introduced), and vacuum pumping is performed, so that heat of the wafer can be taken away, and the etching uniformity can be ensured; moreover, part of the by-products can volatilize quickly.

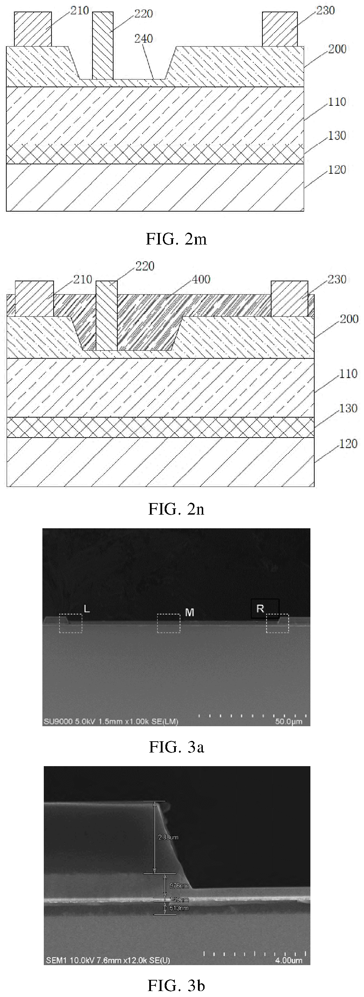

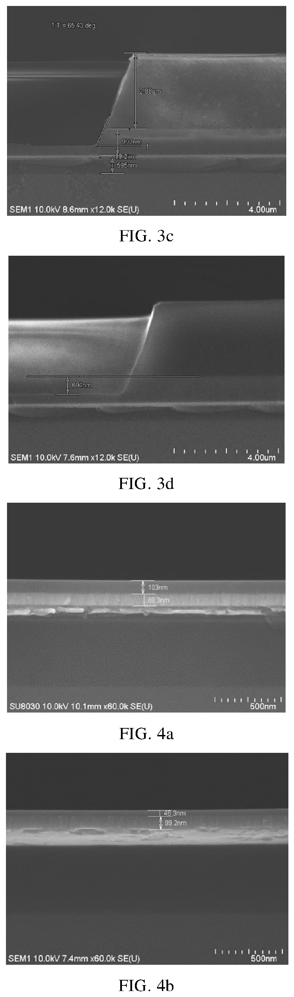

It should be noted that the present embodiment takes the Sc-containing layer made of ScₓAl₁₋ₓN as an example; Sc is a metal element, and can react with chlorine to generate ScCl₃ having certain volatility, but the volatility of ScCl₃ is not good. The etching method provided in the embodiment of the present disclosure can achieve good volatilization of the by-product ScCl₃ in the etching process, so that other Sc-containing materials can be etched with the method provided in the embodiment of the present disclosure. As can be seen from the result characterization diagrams of etching of the Sc-containing layer shown in FIG. 3a and FIG. 3b, with the etching method provided in the embodiment of the present disclosure, there is no obvious by-products on sidewalls, so that the etching process can be smoothly performed at each cycle stage, and the angle (tilt angle) of the etched Sc-containing layer is substantially consistent with the angle (tilt angle) of the etched photoresist, relatively uniform etching is realized, and both the etching rate and the etching quality are ensured. The dimensions indicated in FIG. 3a and FIG. 3b are just approximate values from a specific example, and are just for presenting an angle relationship between the etched Sc-containing layer and the etched photoresist, for example, the angle of the Sc-containing layer and that of the photoresist in FIG. 3a and FIG. 3b are both about 65°. In fact, except for 65°, the angle of the Sc-containing layer and that of the photoresist can both be 75° at the same time. That is, the present disclosure is not limited to the dimensions indicated in the drawings.

As can be seen from FIG. 3a to FIG. 3d, the angle of the ScₓAl₁₋ₓN barrier layer is consistent with that of the photoresist, which indicates that the etching process is not affected by the by-products deposited on the sidewall. It should be further noted that FIG. 3a to FIG. 3d are just for illustrating an etching result, and do not show any structural member of an actual semiconductor device.

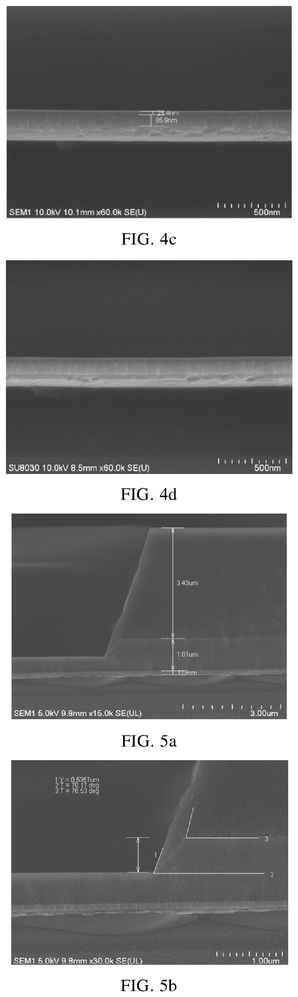

ScₓAl₁₋ₓN barrier layers with different thicknesses may be obtained by adopting an Interferometry End Point (IEP) method or a Laser-Interferometry End Point (LEP) method to indicate an etching end point. As shown in FIG. 4a to FIG. 4d, thicknesses of ScₓAl₁₋ₓN barrier layers obtained by adopting the etching method provided in the embodiment of the present disclosure are about 100 nm (103 nm in FIG. 4a), about 50 nm (46.3 nm in FIG. 4b), and about 30 nm (26.4 nm in FIG. 4c), respectively; and the thickness of the ScₓAl₁₋ₓN barrier layer shown in FIG. 4d is about 10 nm, but the thickness is too small to be indicated, and thus is not indicated. As can be seen from FIG. 4a to FIG. 4d, with the etching method provided in the embodiment of the present disclosure, a thickness range of the Sc-containing layers manufactured by etching is relatively wide, and the etching thicknesses can be easily controlled, that is, not only a thicker Sc-containing layer (e.g., the ScₓAl₁₋ₓN barrier layer with the thickness of 100 nm) but also a thinner Sc-containing layer (e.g., the ScₓAl₁₋ₓN barrier layers with the thicknesses less than 10 nm) can be manufactured by etching. By introducing a recessed gate structure to manufacturing of a semiconductor device including a Sc-containing layer, a normally-off semiconductor device such as a normally-off transistor including a Sc-containing layer can be manufactured.

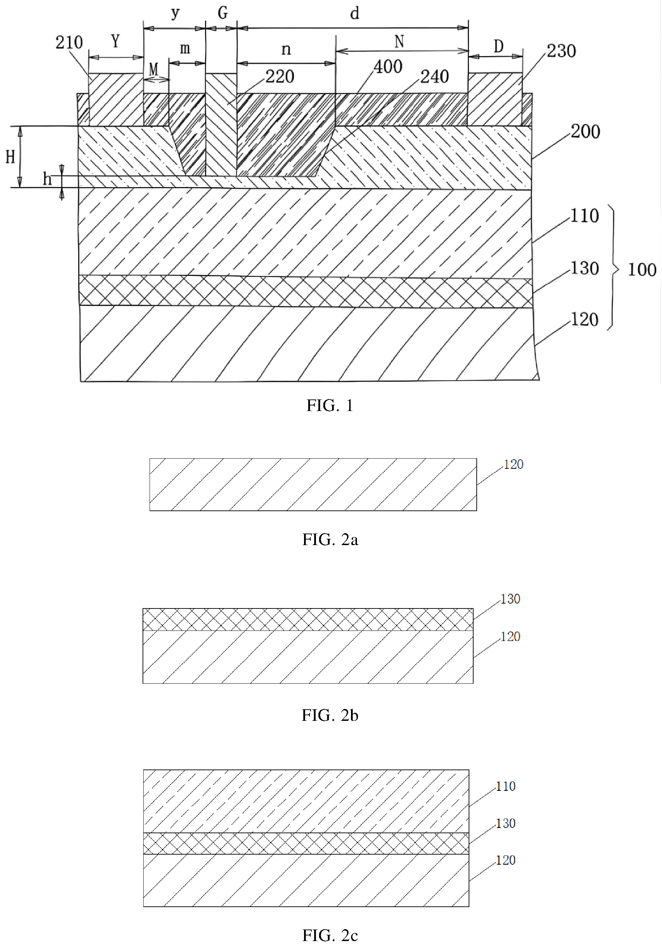

It should be noted that the characterization diagrams do not show any part of an actual semiconductor device, but are just for exemplarily illustrating the etching result, the characterization diagrams can simulate an processing effect of a semiconductor device manufactured with a method (a manufacturing method of a semiconductor device including a Sc-containing layer, which will be described in detail below in a second embodiment) illustrated by FIG. 2a to FIG. 2n, and the processing effect can be characterized by Scanning Electron Microscope (SEM) instead of Transmission Electron Microscope (TEM).

It should be noted that FIG. 3a to FIG. 3d and FIG. 4a to FIG. 4d in the present disclosure are all electron micrographs; and in order to facilitate presentation of contrast, a metal layer is disposed under the ScₓAl₁₋ₓN layer during experiment, the metal layer is thin and has a thickness less than 100 nm, and the ScₓAl₁₋ₓN layer is not to be etched to a level where the metal layer is located, so the metal layer does not affect the etching result of the ScₓAl₁₋ₓN layer, that is, neither the metal layer nor a GaN layer under the ScₓAl₁₋ₓN layer may affect the etching result. Therefore, a GaN layer may be disposed under the ScₓAl₁₋ₓN layer when manufacturing the semiconductor device including the Sc-containing layer. In addition, the dimensions indicated in FIG. 4a to FIG. 4d are just approximate values from a specific example, and are just for presenting the ScₓAl₁₋ₓN barrier layers with the different thicknesses which can be manufactured by etching. That is, the present disclosure is not limited to the dimensions indicated in the drawings.

In addition, in the embodiment of the present disclosure, the first etching step may include a bombardment step and/or an etching step, and the second etching step may include a bombardment step and/or an etching step; or the first etching step may be a bombardment step, and the second etching step may be an etching step, which is not limited in the present disclosure.

The etching method provided in the embodiment of the present disclosure is further compared and described in conjunction of the following comparative examples.

### First Comparative Example

In the present comparative example, x of ScₓAl₁₋ₓN satisfies x=20%, that is, a molar ratio of Sc is 20%. ScₓAl₁₋ₓN is etched using a process recipe shown in Table 3, and an ESC (Electrostatic Chuck) temperature is 40°C.

**Table 3 plasma etching process recipe in first comparative example**

| process step | chamber pressure/ mTorr | upper-electrode center power/W | upper-electrode edge power/W | lower electrode power/W | flow rate of BCl₃/ sccm | flow rate of Cl₂/ sccm | flow rate of Ar/ sccm | process time/s |
|---|---|---|---|---|---|---|---|---|
| stabilization step | 5 | 0 | 0 | 0 | 20 | 20 | 100 | 5 |
| ignition step | 5 | 600 | 1000 | 0 | 20 | 20 | 100 | 5 |
| main etching step | 5 | 600 | 1500 | 400 | 20 | 20 | 100 | 240 |
| desorption step | 50 | 500 | 500 | 0 | 0 | 100 | 200 | 5 |

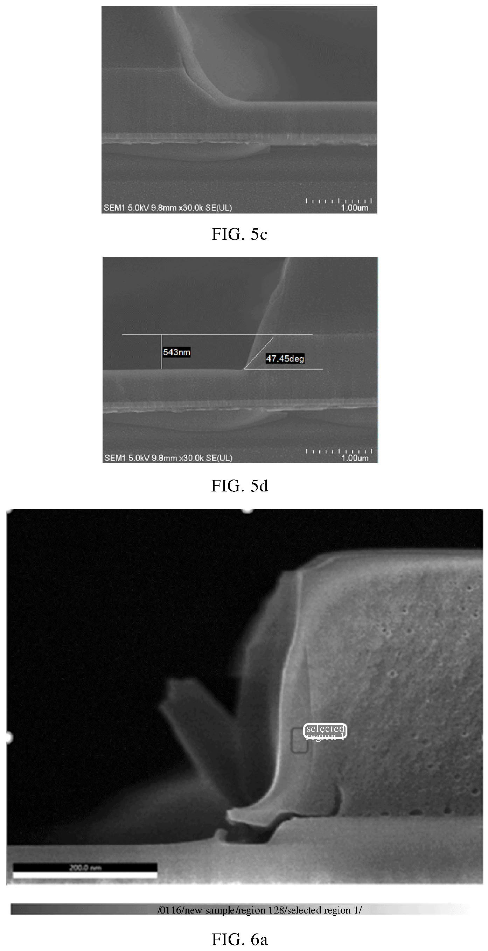

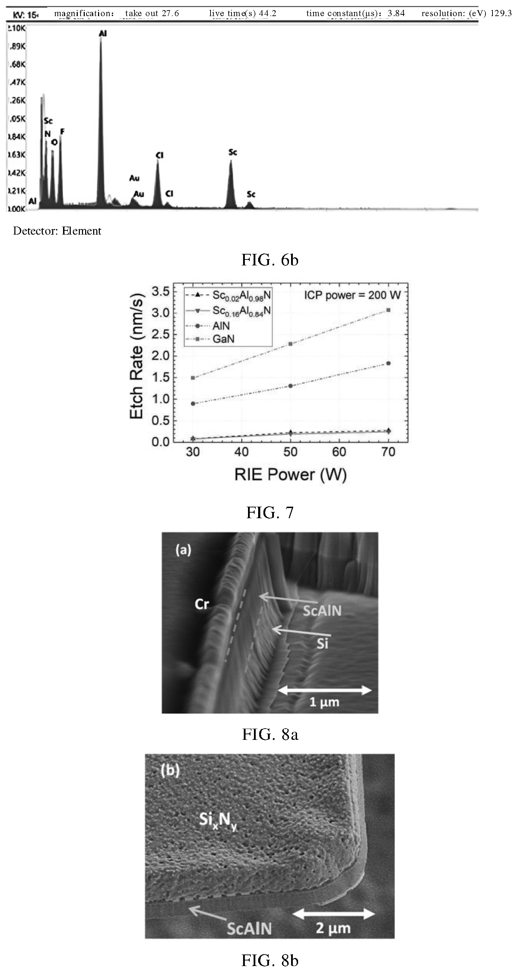

In the first comparative example, the main etching step does not adopt the cyclic execution of the main etching process step and the auxiliary etching process step provided in the embodiment of the present disclosure, and only adopts the etching step, and the process parameters of the main etching step are shown in Table 3. Referring to FIG. 5a to FIG. 5d, as indicated by the SEM characterization results, the sidewalls suffer from deposition of the by-products, resulting in angle deviation; and the angle of the photoresist is about 75° while the angle of ScₓAl₁₋ₓN is just about 47°, and the two tilt angles differ greatly. It should be noted that FIG. 5a to FIG. 5a 5d are just for illustrating the etching result, and do not illustrate the semiconductor device shown in FIG. 2a to FIG. 2n. Energy Dispersive X-Ray characterization of the by-products on the sidewalls shows that the by-products contain Sc, as shown in FIG. 6a and FIG. 6b, and it is indicated that the by-products are caused by the fact that ScCl₃ is hard to volatilize and lead to the significant difference between the angles of the etched photoresist and the etched ScₓAl₁₋ₓN.

### Second Comparative Example

In the second comparative example, according to an article entitled A NOVEL BARRIER MATERIAL FOR HIGH POWER GAN-BASED RF TRANSISTORS published by M.T. Hardy et al, ScₓAl₁₋ₓN is etched under the conditions of an upper electrode power of 200 W and a lower electrode power of 30 W to 70 W, and as shown in a statistical chart of results in FIG. 7a, a relatively low etching rate is achieved.

### Third Comparative Example

In the third comparative example, according to an article entitled FABRICATION AND CHARACTERISATION OF SCALN-BASED PIEZOELECTRIC MEMS CANTILEVERS published by P.M. Mayrhofer et al, ScₓAl₁₋ₓN is etched under the conditions that an etching gas includes SiCl₄, a chamber pressure is 15 mTorr, an upper electrode power is 150 W, and a lower electrode power is 225W, and as can be seen from characterization diagrams of etching results in FIG. 8a and FIG. 8b, a relatively low etching rate which is just 10 nm/min is achieved.

### Fourth Comparative Example

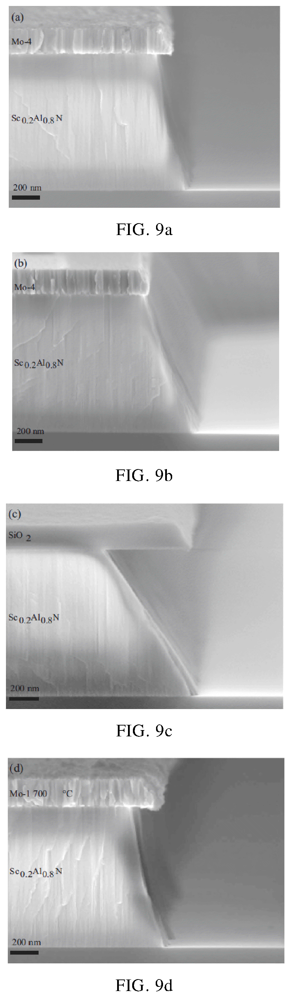

In the fourth comparative example, according to an article entitled HIGH-FIDELITY PATTERNING OF ALN AND SCALN THIN FILMS WITH WET CHEMICAL ETCHING published by Konsta Airola et al, etching profiles of ScₓAl₁₋ₓN as shown in FIG. 9a to FIG. 9d are obtained under different wet etching conditions. As can be seen from the drawings, although an etching rate higher than 100 nm/min can be achieved, a solution can hardly enter an etching surface in a case where a semiconductor device has a relatively small size, and an acidic or alkaline solution used for etching also affects other structures in the device.

As can be seen from the above comparative analysis of the comparative examples, the etching method for a Sc-containing layer provided in the embodiment of the present disclosure can achieve relatively high etching rate and etching uniformity due to the adoption of the main etching process step and the auxiliary etching process step which are performed cyclically, so that the etching efficiency and the etching quality can be ensured, the angle consistency of the Sc-containing layer and the photoresist can be realized, the Sc-containing layers with different thicknesses can be manufactured by etching, and thinning design of the Sc-containing layer can be realized, and a technical support for manufacturing of normally-off semiconductor devices is provided.

### Second Embodiment

An embodiment of the present disclosure provides a manufacturing method for a semiconductor device, including:
S210, providing a substrate;
S220, forming a Sc-containing layer on the substrate, with the Sc-containing layer being capable of serving as a barrier layer, and a ScₓAl₁₋ₓN barrier layer taken as an example;
S230, etching the Sc-containing layer with the etching method provided in the first embodiment to form a recess with a preset depth, with the preset depth being smaller than a thickness of the Sc-containing layer; and
S240, forming a gate in the recess, and forming a source and a drain on two sides of the recess.

The adoption of the etching method for a Sc-containing layer provided in the embodiment of the present disclosure can produce the same beneficial effects as the etching method, that is, the etching efficiency can be improved, which will not be described here.

In the present embodiment of the present disclosure, step S220 includes the following sub-steps:
S2202, obtaining a Sc precursor by electron beam evaporation;
S2204, obtaining an Al precursor with a filament effusion cell; and
S2206, depositing and growing a ScₓAl₁₋ₓN barrier layer on the substrate with a Molecular Beam Epitaxy (MBE) method, which have such process parameters that a temperature is 500°C to 900°C and a flow rate of nitrogen is 0.1 sccm to 10 sccm.

In the present embodiment of the present disclosure, step S210 includes the following sub-steps:
S2102, taking the cleaned substrate;
S2104, depositing a buffer layer on the substrate; and
S2106, depositing an epitaxial layer on the buffer layer.

In a case where the buffer layer includes a first buffer layer and a second buffer layer, sub-step S2104 further includes:
(1) introducing trimethylaluminum and ammonia into a reaction chamber, and depositing the first buffer layer on the substrate, with a thickness of the first buffer layer being 4 nm to 6 nm, such as 5nm, a temperature being 680°C to 720°C, such as 700°C, and a deposition growth rate being 0.8 nm/min to 1.2 nm/min, such as 1 nm/min; and
(2) continuously introducing trimethylaluminum and ammonia into the reaction chamber, and forming the second buffer layer on the first buffer layer, with a thickness of the second buffer layer being 4 nm to 96 nm, the temperature being 780°C to 820°C, such as 800°C, and the deposition growth rate being 4.5 nm/min to 5.5 nm/min, such as 5 nm/min.

Sub-step S2106 includes: introducing trimethylgallium and ammonia into the reaction chamber, and depositing the epitaxial layer on the second buffer layer, with the temperature being 1050°C to 1150°C, such as 1100°C.

Sub-step S2102 includes:
(1) selecting the substrate, which is a sapphire substrate, a silicon carbide substrate, or a silicon substrate;
(2) selecting a cleaning solvent, which is a mixed solution of concentrated sulfuric acid with a concentration of 98% and hydrogen peroxide with a concentration of 30%, with a volume ratio of the concentrated sulfuric acid with the concentration of 98% to the hydrogen peroxide with the concentration of 30% being 6:4 to 8:2, such as 7:3;
(3) placing the substrate in the cleaning solvent, heating to a preset cleaning temperature, and continuously heating for at least 30 minutes until bubbles disappear, with the preset cleaning temperature being 105°C to 115°C, such as 110°C; and
(4) taking the substrate out of the cleaning solvent, and rinsing the substrate thoroughly with ultrapure water.

In the present embodiment of the present disclosure, step 230 includes the following sub-steps S2302, S2304, and S2306.

At S2302, a first photoresist is spin-coated on the barrier layer, and the first photoresist is exposed, developed, and fixed to obtain a first mask having a first opening, with a portion of the barrier layer exposed by the first opening being a position of the recess.

A thickness of the first photoresist is 0.5 µm to 10 µm, such as 3 µm; an exposure time is 3 s to 20 s, such as 6 s; a development time is 45 s to 120 s, such as 75 s; and a fixing time is 60 s to 300 s, such as 120 s.

At S2304, the first mask and the barrier layer are etched, with a region corresponding to the first opening being etched to form the recess.

The steps in the etching method provided in the first embodiment are adopted at the etching process step S2304, and include the stabilization step, the ignition step, the main etching process step, the auxiliary etching process step, and the desorption step, the main etching process step and the auxiliary etching process step are performed cyclically, the main etching process step includes at least one of the first etching step or the second etching step, the auxiliary etching process step includes at least one of the volatilization step or the cooling step, and each process step and the process parameters thereof can be found in the first embodiment, and thus will not be described here.

At S2306, the first photoresist and by-products are removed. Sub-step S2306 includes:
(1) in the presence of a residue of the first photoresist, soaking and rinsing the first photoresist with an organic solution until the first photoresist completely falls off; and
(2) removing the by-products of the first photoresist and the by-products generated by the etching process at S2304.

In the present embodiment of the present disclosure, step S240 includes the following sub-steps S2402, S2404, S2406, S2408, S2410, and S2412.

At S2402, a second photoresist is spin-coated on the barrier layer provided with the recess, and the second photoresist is exposed, developed, and fixed to obtain a second mask having a second opening and a third opening, with a portion of the barrier layer exposed by the second opening being a source position, and a portion of the barrier layer exposed by the third opening being a drain position.

A thickness of the second photoresist is 0.5 µm to 10 µm, such as 1 µm to 5 µm, and may be 3 µm; a width of the second opening is 5 µm to 500 µm, such as 6 µm to 200 µm, or 7 µm to 100 µm, or 8 µm to 50 µm, and may be 10 µm; a width of the third opening is 5 µm to 500 µm, such as 6 µm to 200 µm, or 7 µm to 100 µm, or 8 µm to 50 µm, and may be 10 µm; an exposure time is 3 s to 20 s, such as 5 s to 10 s, and may be 6 s; a development time is 45 s to 120 s, such as 60 s to 100 s, and may be 75 s; and a fixing time is 60 s to 300 s, such as 80 s to 200 s, and may be 120 s.

At S2404, metal ion deposition is performed on the second photoresist and the source position and the drain position of the barrier layer to form the source and the drain; or thermal evaporation is performed on the barrier layer to form the source and the drain.

When a Physical Vapor Deposition (PVD) process is adopted and performed, Ti ions and Al ions are sequentially deposited to obtain a Ti layer and an Al layer; a chamber pressure in the reaction chamber is 10 mTorr to 100 mTorr; and an upper electrode power is 750 W to 3000 W, a lower electrode power is 5 W to 500 W, a process gas includes argon, and a flow rate of argon is 50 sccm to 500 sccm. Alternatively, during a thermal evaporation process, the chamber pressure in the reaction chamber is 5×10⁻⁵ Pa to 5×10⁻⁴ Pa, such as 1×10⁻⁴ Pa, and a current is 1 mA to 20 mA, such as 5 mA.

At S2406, the second photoresist and by-products are removed. Sub-step S2406 includes:
(1) in the presence of a residue of the second photoresist, soaking and rinsing the second photoresist with an organic solution until the second photoresist completely falls off; and
(2) removing the by-products of the second photoresist and the by-products generated by the deposition process at S2404, or removing the by-products of the second photoresist and the by-products generated by the thermal evaporation process at step S2404.

At S2408, a third photoresist is spin-coated on the barrier layer provided with the recess, the source, and the drain, and the third photoresist is exposed, developed, and fixed to obtain a third mask having a fourth opening, with a portion of the barrier layer exposed by the fourth opening being a gate position which is in the recess.

A thickness of the third photoresist is 0.5 µm to 10 µm, such as 1 µm to 5 µm, and may be 3 µm; an exposure time is 3 s to 20 s, such as 5 s to 10 s, and may be 6 s; a development time is 45 s to 120 s, such as 60 s to 100 s, and may be 75 s; and a fixing time is 60 s to 300 s, such as 80 s to 200 s, and may be 120 s.

At S2410, metal ion deposition is performed on the third photoresist and the gate position in the recess to form the gate, or thermal evaporation is performed on the gate position in the recess to form the gate.

A PVD process is adopted, and Ni ions and Au ions are sequentially deposited to obtain a Ni layer and an Au layer; the chamber pressure in the reaction chamber is 10 mTorr to 100 mTorr; the upper electrode power is 750 W to 3000 W, and the lower electrode power is 5 W to 500 W; and the process gas includes argon, and the flow rate of argon is 50 sccm to 500 sccm. Alternatively, during a thermal evaporation process, the chamber pressure in the reaction chamber is 5×10⁻⁵ Pa to 5×10⁻⁴ Pa, such as 1×10⁻⁴ Pa, and the current is 1 mA to 20 mA, such as 5 mA.

At S2412, the third photoresist and by-products are removed. Sub-step S2412 includes:
(1) in the presence of a residue of the third photoresist, soaking and rinsing the third photoresist with an organic solution until the third photoresist completely falls off; and
(2) removing the by-products of the third photoresist and the by-products generated by the deposition process at S2410, or removing the by-products of the third photoresist and the by-products generated by the thermal evaporation process at step S2410.

In the embodiment of the present disclosure, after step S240, the method further includes:
S250, performing depositing on the barrier layer provided with the source, the gate, the drain, and the recess to form a passivation layer.

During a deposition process at this step, the passivation layer is formed by Plasma-Enhanced Chemical Vapor Deposition (PECVD) or High-Density Plasma Chemical Vapor Deposition (HDPCVD); the passivation layer includes a SiN layer and a SiO₂ layer; the chamber pressure in the reaction chamber is 1 mTorr to 1000 mTorr, the chamber pressure is, for example, 5 mTorr in a case where the HDPCVD is adopted, and the chamber pressure is, for example, 500 mTorr in a case where the PECVD is adopted; the upper electrode power is 500 W to 15000 W, such as 5000 W; the lower electrode power is 0 to 15000 W, such as 5000 W; the process gas includes SiH₄ and O₂, a flow rate of SiH₄ is 10 sccm to 1000 sccm, such as 50 sccm, and a flow rate of O₂ is 10 sccm to 1000 sccm, such as 500 sccm; and a coolant temperature of a base is -15°C to 100°C, such as 40°C.

In the embodiment of the present disclosure, after step S250, the method further includes:
S260, performing packaging and cutting to obtain a semiconductor device including a Sc-containing layer, such as a transistor including a Sc-containing layer.

In order to further explain the manufacturing method for a semiconductor device provided in the present embodiment of the present disclosure, an exemplary example is described in detail below, which includes the following steps S301 to S315.

At S301, cleaning of the substrate is performed to obtain the substrate meeting cleanliness requirements, as shown in FIG. 2a. A substrate 120 may be selected from a sapphire substrate, a silicon carbide substrate, or a silicon substrate. Taking selecting the silicon substrate as an example, an RCA standard cleaning method is adopted, commercially available concentrated sulfuric acid with the concentration of 98% and commercially available hydrogen peroxide with the concentration of 30% are mixed at the volume ratio of 7:3, the silicon substrate is placed in the mixed solution, the mixed solution is heated to 110°C until bubbles disappear (heated for at least 30 minutes), and the silicon substrate is taken out and rinsed thoroughly with ultrapure water.

At S302, an AlN buffer layer is grown by Metal-Organic Chemical Vapor Deposition (MOCVD), with a thickness of the AlN buffer layer being 10 nm to 100 nm, such as 40 nm, as shown in FIG. 2b. For example, trimethylaluminum and ammonia are introduced into the reaction chamber, the reaction chamber is heated to 700°C, a growth rate is controlled to 1 nm/min, and an AlN nucleation layer with a thickness of 5 nm is deposited on the substrate 120; then, trimethylaluminum and ammonia are continuously introduced, the temperature in the chamber is raised to 800°C, the growth rate is increased to 5 nm/min, and the AlN buffer layer 130 is formed.

At S303, based on step S302, the introduction of trimethylaluminum is stopped, trimethylgallium and ammonia are introduced into the reaction chamber, the temperature in the chamber is raised to 1100°C, and a GaN epitaxial layer 110 is deposited on the AlN buffer layer 130, as shown in FIG. 2c. A thickness of the GaN epitaxial layer 110 is 1 µm to 10 µm, such as 3 µm.

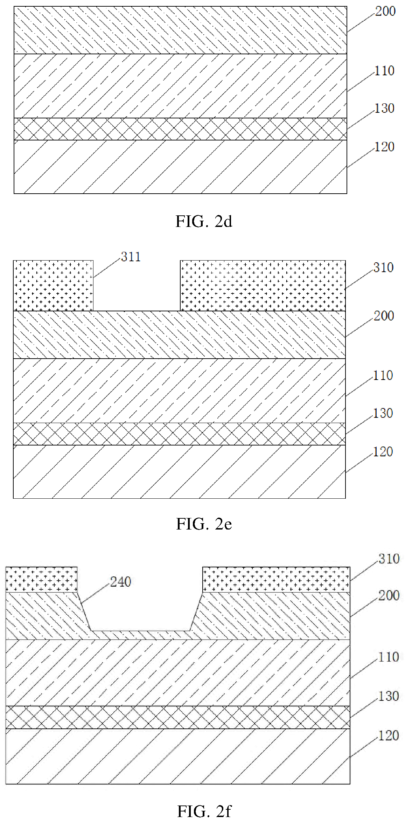

At S304, growth of ScₓAl₁₋ₓN is performed with the MBE method to obtain an epitaxial layer 200, as shown in FIG. 2d. A thickness of the epitaxial layer 200 is 0.01 µm to 1 µm, the temperature is 500°C to 900°C, the flow rate of nitrogen is 0.1 sccm to 10 sccm, the Sc precursor may be obtained by electron beam evaporation, and the Al precursor may be obtained with the filament effusion cell.

At S305, the photoresist is spin-coated to form a first photoresist layer 310 having a first opening 311, as shown in FIG. 2e. A thickness of the first photoresist layer 310 is 0.5 µm to 10 µm, such as 3 µm. The photoresist is exposed and developed. Design and processing of the mask are performed in advance, such that the first opening 311, i.e., the recess (respectively calculated from two ends of the recess) is kept apart from the source and the drain by a distance of 0.3 µm and a distance of 1 µm, respectively. The exposure time is 3 s to 20 s, such as 6 s; the development time is 45 s to 120 s, such as 75 s; and the fixing time is 60 s to 300 s, such as 120 s. Thus, the photoresist is patterned.

It should be noted that for a voltage withstanding device, a distance between a gate and a drain can affect a voltage which the device can withstand; and for a radio frequency device, a distance between a gate and a source can affect current density, on-resistance, and transconductance peak of the device, and those parameters can be improved by reducing the distance between the gate and the source. Therefore, the distance between the gate and the drain is set to be 1 to 5 times the distance between the gate and the source, that is, a ratio of the distance between the gate and the drain to the distance between the gate and the source is (1-5):1.

At S306, plasma etching of ScₓAl₁₋ₓN is performed to form a recess 240, as shown in FIG. 2f. The chamber pressure is 1 mTorr to 30 mTorr, such as 5 mTorr, the upper electrode power is 500 W to 3000 W, the upper-electrode center power is, for example, 600 W, and the upper-electrode edge power is, for example, 1500 W; the lower electrode power at the main etching process step is 100 W to 1000 W, the lower electrode power at the first etching step is, for example, 600 W, and the lower electrode power at the second etching step is, for example, 400 W; the lower electrode power at the auxiliary etching process step is close to zero, such as 1W; the flow rate of Ar at the main etching process step is 10 sccm to 1000 sccm, such as 100 sccm, the flow rate of BCl₃ is 10 sccm to 100 sccm (other chlorine-containing gases such as SiCl₄ may be used), such as 20 sccm, and the flow rate of Cl₂ is 10 sccm to 100 sccm (other chlorine-containing gases such as SiCl₄ may be used); the flow rate of the process gases at the auxiliary etching process step are close to zero, the flow rate of the chlorine-containing gas and the flow rate of Ar at the volatilization step are both, for example, 1 sccm, the flow rate of the chlorine-containing gas at the cooling step is, for example, 1 sccm, and the flow rate of Ar is, for example, 10 sccm; and the coolant temperature of the base is -15°C to 60°C, such as 40°C.

The steps in the etching method provided in the first embodiment are adopted at the etching process step S306, and include the stabilization step, the ignition step, the main etching process step, the auxiliary etching process step, and the desorption step, the main etching process step and the auxiliary etching process step are performed cyclically, the main etching process step includes at least one of the first etching step or the second etching step, the auxiliary etching process step includes at least one of the volatilization step or the cooling step, and each process step and the process parameters thereof can be found in the first embodiment, and thus will not be described here.

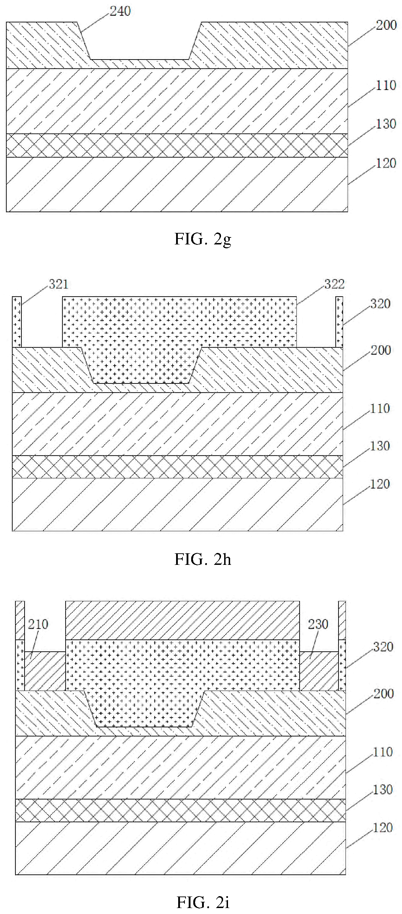

At S307, wet photoresist stripping is performed to remove the first photoresist layer 310, as shown in FIG. 2g. An organic solution such as acetone is used, the time is not limited herein, the soaking is ended when most of the photoresist falls off a surface of the Sc-containing layer, and then the photoresist is rinsed with the flowing organic solution until the photoresist completely falls off the surface of the Sc-containing layer, thereby removing residues of the photoresist and the by-products of the etching process.

At S308, the photoresist is spin-coated to form a second photoresist layer 320 having a second opening 321 and a third opening 322, as shown in FIG. 2h. A thickness of the second photoresist layer 320 is 0.5 µm to 10 µm, such as 3 µm. The photoresist is exposed and developed. Design and processing of the mask are performed in advance, such that electrode widths of a source and a drain are about 5 µm to 500 µm, such as 10 µm. The exposure time is 3 s to 20 s, such as 6 s; the development time is 45 s to 120 s, such as 75 s; and the fixing time is 60 s to 300 s, such as 120 s. Thus, the photoresist is patterned.

At S309, metal Ti/Al of a source 210 and a drain 230 is prepared to form ohmic contact with a conductive channel, as shown in FIG. 2i. For example, PVD is adopted, a Ti thickness is 0.05 µm to 0.2 µm, such as 0.1 µm, and an Al thickness is 0.1 µm to 0.5 µm, such as 0.3 µm. The process conditions are such that the chamber pressure is 10 mTorr to 100 mTorr, the upper electrode power is 750 W to 3000 W, the lower electrode power is 5 W to 500 W, and the flow rate of Ar is 50 sccm to 500 sccm. In some embodiments, thermal evaporation may be adopted at this step, with the chamber pressure being 5×10⁻⁵ Pa to 5×10⁻⁴ Pa, such as 1×10⁻⁴ Pa, and the current being 1 mA to 20 mA, such as 5 mA.

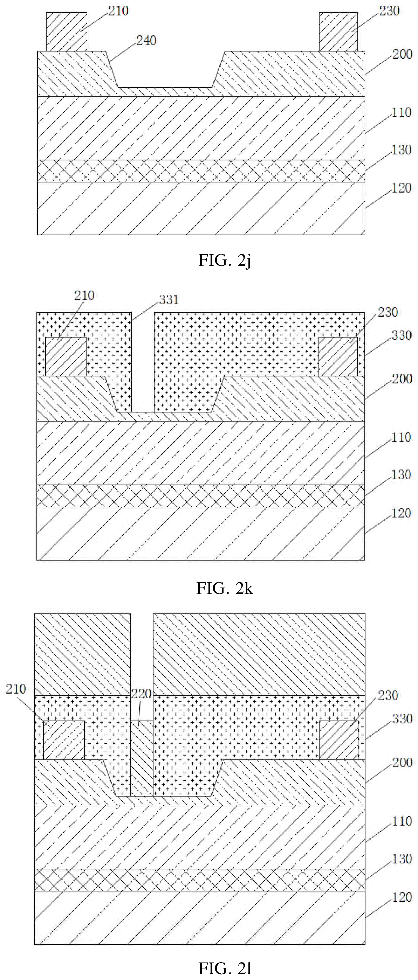

At S310, wet photoresist stripping is performed to remove the second photoresist layer 320, as shown in FIG. 2j. This step is substantially the same as step S307.

At S311, the photoresist is spin-coated to form a third photoresist layer 330 having a four opening 331 with a thickness being 0.5 µm to 10 µm, such as 3 µm, as shown in FIG. 2k. The photoresist is exposed and developed. Design and processing of the mask are performed in advance, such that a distance between metal of a gate of the device and the metal of the drain 230 is about 1 µm to 10 µm, such as 5 µm; a distance between the metal of the gate and the metal of the source 210 is about 0.5 µm to 5 µm, such as 1 µm; a gate length is about 0.5 µm to 5 µm, such as 1 µm, and a gate width is about 0.1 mm to 10 mm, such as 3 mm; and an active area (i.e., an area including the source and the drain) of the semiconductor device is about 1×10⁻⁴ cm² to 10×10⁻⁴ cm². The exposure time is 3 s to 20 s, such as 6 s; the development time is 45 s to 120 s, such as 75 s; and the fixing time is 60 s to 300 s, such as 120 s. Thus, the photoresist is patterned.

At S312, metal Ni/Au of a gate 220 is prepared, as shown in FIG. 2l. In an embodiment, a thickness of Ni is 1 nm to 10 nm, such as 5 nm, and a thickness of Au is 10 nm to 100 nm, such as 50 nm. Like step S309, PVD or thermal evaporation may be adopted at this step.

At S313, wet photoresist stripping is performed to remove the third photoresist layer 330, as shown in FIG. 2m. This step is substantially the same as step S307.

At S314, a passivation layer 400 is deposited on a surface of the semiconductor device by PECVD or HDPCVD to protect the semiconductor device, as shown in FIG. 2n. Taking the passivation layer 400 including a SiN layer with a thickness of 300 nm and a SiO₂ layer with a thickness of 600 nm as example, the process parameters at this step are such that the chamber pressure is 1 mTorr to 1000 mTorr, the chamber pressure is, for example, 5 mTorr in a case where the HDPCVD is adopted, and the chamber pressure is, for example, 500 mTorr in a case where the PECVD is adopted; the upper electrode power is 500 W to 15000 W, such as 5000 W; the lower electrode power is 0 to 15000 W, such as 5000 W; the flow rate of SiH₄ is 10 sccm to 1000 sccm, such as 50 sccm, and the flow rate of O₂ is 10 sccm to 1000 sccm, such as 500 sccm; and the coolant temperature of the base is -15°C to 100°C, such as 40°C.

At S315, packaging and cutting are performed.

An embodiment of the present disclosure further provides a semiconductor device, including: a substrate, a Sc-containing layer, a source, a drain, and a gate. The Sc-containing layer is disposed above the substrate, a recess is formed in the Sc-containing layer on a side away from the substrate, and a depth of the recess is smaller than a thickness of the Sc-containing layer; the source is disposed on a first side of the recess; the drain is disposed on a second side of the recess, the second side is opposite to the first side, and a distance between the source and an edge of the recess on the first side is smaller than a distance between the drain and an edge of the recess on the second side; and the gate is disposed in the recess, and a distance between the gate and the source is smaller than a distance between the gate and the drain. In the present embodiment, the recess may be formed, for example, with the above etching method for a Sc-containing layer. It can be easily understood that the source and the drain are both disposed on a side of the Sc-containing layer away from the substrate and outside the recess; and the first side and the second side of the recess respectively refer to outer sides of two side surfaces of the recess.

The semiconductor device includes the Sc-containing layer which serves as a barrier layer, the Sc-containing layer is etched with the above etching method to form the recess with a preset depth, and the recess and the gate in the recess form a recessed gate structure, which can, compared with the related technology, enable thinning of the barrier layer where the gate is located. With such configuration, when a gate voltage is applied to the gate for regulation, a potential well is formed, and a two-dimensional electron gas is generated, so that high electron mobility in the semiconductor device can be realized; when no gate voltage is applied, the potential well for the two-dimensional electron gas disappears, and the semiconductor device is in an off state, that is, the semiconductor device becomes a normally-off semiconductor device, so that safety control performance of the semiconductor device can be realized.

In the embodiment of the present disclosure, the Sc-containing layer contains ScₓAl₁₋ₓN, a value of x is less than 43%, and is, for example, 20% to 40%, or 22% to 38%, or 25% to 35%, or 28% to 32%, and may be 30%; a distance between a bottom of the recess and a side of the Sc-containing layer facing the substrate is 1 nm to 100 nm, such as 2 nm to 20 nm, or 3 nm to 10 nm, and may be 5 nm; the distance between the source and the edge of the recess on the first side is 0.1 µm to 0.5 µm; the distance between the drain and the edge of the recess on the second side is 0.5 µm to 5 µm; and a length of the gate is 0.5 µm to 5 µm, such as 0.6 µm to 2 µm, and may be 1 µm, and a width of the gate is 0.1 mm to 10 mm, such as 1 mm to 5 mm, and may be 3 mm.

Taking what is manufactured is a semiconductor device (e.g., a transistor) including a Sc-containing layer as an example, as shown in FIG. 1, the semiconductor device includes a substrate 120, the Sc-containing layer (i.e., a barrier layer 200), a source 210, a drain 230, and a gate 220. The Sc-containing layer is disposed above the substrate 120; a recess 240 is formed in the Sc-containing layer on a side away from the substrate 120, and a depth of the recess 240 is smaller than a thickness of the Sc-containing layer; the source 210 is disposed on a first side of the recess 240; the drain 230 is disposed on a second side of the recess 240, the second side is opposite to the first side, and a distance between the source 210 and an edge of the recess 240 on the first side is smaller than a distance between the drain 230 and an edge of the recess 240 on the second side; and the gate 220 is disposed in the recess 240, and a distance between the gate 220 and the source 210 is smaller than a distance between the gate 220 and the drain 230.

In the present embodiment, a buffer layer 130 and an epitaxial layer 110 are further disposed between the substrate 120 and the Sc-containing layer, and the epitaxial layer 110, the buffer layer 130, and the substrate 12 are sequentially arranged from top to bottom to form an epitaxial wafer 100. Referring to FIG. 1, the barrier layer 200 is deposited on the epitaxial layer 110 of the epitaxial wafer 100, the recess 240 is formed in the barrier layer 200 on a side away from the substrate 120, and the source 210 is disposed on the first side of the recess 240; the drain 230 is disposed on the second side of the recess 240, the gate 220 is disposed in the recess 240, the source 210, the gate 220, and the drain 230 are spaced apart from each other by the recess 240, an opening of the recess 240 is away from the epitaxial layer 110, and a bottom of the recess 240 does not reach the epitaxial layer 110, that is, the depth of the recess 240 is smaller than the thickness of the barrier layer 200, and the gate 220 is located in the recess 240; and the barrier layer 200 is the Sc-containing layer. The barrier layer 200 being a ScₓAl₁₋ₓN barrier layer is still taken as an example in the present embodiment.

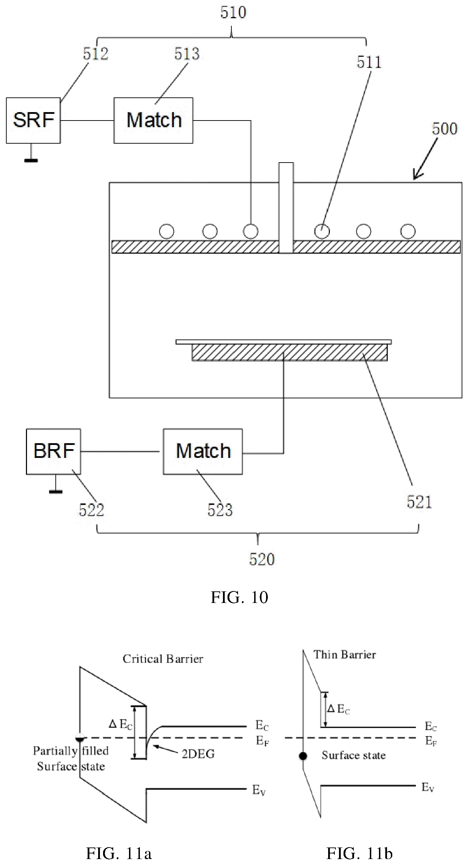

A distance h between the bottom of the recess 240 and a side of the Sc-containing layer facing the substrate is 1 nm to 100 nm, such as 2 nm to 20 nm, or 3 nm to 10 nm, and may be 5 nm; the recess 240 has a first edge (i.e., the edge on the first side) and a second edge (i.e., the edge on the second side), which are opposite to each other, the first edge is located between the gate 220 and the source 210, and the second edge is located between the gate 220 and the drain 230; the distance M from the first edge to the source 210 is 0.1 µm to 0.5 µm, and the distance N from the second edge to the drain 230 is 0.5 µm to 5 µm; a length G of the gate 220 is 0.5µm to 5 µm, such as 0.6 µm to 2 µm, and may be 1 µm; a width of the gate 220 is 0.1 mm to 10 mm, such as 1 mm to 5 mm, and may be 3 mm. With such configuration, as shown in FIG. 11a, when a gate voltage is applied to the gate for regulation, a potential well is formed, and a two-dimensional electron gas is generated, so that high electron mobility in the semiconductor device can be realized; as shown in FIG. 11b, when no gate voltage is applied, the potential well for the two-dimensional electron gas disappears, and the semiconductor device is in an off state, that is, the semiconductor device becomes a normally-off semiconductor device, so that safety control performance of the semiconductor device can be realized.

The thickness H of the barrier layer 200 is 0.01 µm to 1 µm, such as 0.01 µm to 0.5 µm, or 0.01 µm to 0.1 µm, or 0.01 µm to 0.05 µm, and may be 0.03 µm. Taking the epitaxial layer 110 being a GaN epitaxial layer as an example, a thickness of the GaN epitaxial layer is 1 µm to 10 µm, such as 2 µm to 5 µm, and may be 3 µm.

A length Y of the source 210 is 5 µm to 500 µm, such as 6 µm to 100 µm, or 7 µm to 50 µm, and may be 10 µm. The source 210 includes a Ti layer and an Al layer, and the Ti layer is located between the barrier layer 200 and the Al layer; a thickness of the Ti layer is 0.05 µm to 0.2 µm, such as 0.1 µm; and a thickness of the Al layer is 0.1 µm to 0.5 µm, such as 0.3 µm.

A length D of the drain 230 is 5 µm to 500 µm, such as 6 µm to 100 µm, or 7 µm to 50 µm, and may be 10 µm. The size of the drain 230 may be the same as that of the source 210. For example, the drain 230 includes a Ti layer and an Al layer, and the Ti layer is located between the barrier layer 200 and the Al layer; a thickness of the Ti layer is 0.05 µm to 0.2 µm, such as 0.1 µm; and a thickness of the Al layer is 0.1 µm to 0.5 µm, such as 0.3 µm.

The gate 220 includes a Ni layer and an Au layer, the Ni layer is located between the barrier layer 200 and the Au layer, and a thickness of the Ni layer is 1 nm to 10 nm, such as 5 nm; and a thickness of the Au layer is 10 nm to 100 nm, such as 50 nm.

The distance y between the gate 220 and the source 210 is 0.5 µm to 5 µm, such as 1 µm; the distance d between the gate 220 and the drain 230 is 1 µm to 10 µm, such as 5 µm; the distance d between the gate 220 and the drain 230 is set as a first distance, the distance y between the gate 220 and the source 210 is set as a second distance, and a ratio d/y of the first distance to the second distance is 1 to 5.

The distance m between the first edge of the recess 240 and the gate 220 is 0.1 µm to 1 µm, such as 0.2 µm to 5 µm, and may be 0.3 µm; and the distance n between the second edge of the recess 240 and the gate 220 is 0.3 µm to 5 µm, such as 0.5 µm to 3 µm, and may be 1 µm.

In the embodiment of the present disclosure, the buffer layer 130 is an AlN buffer layer, and a thickness of the buffer layer 130 is 10 nm to 100 nm, such as 20 nm to 60 nm, and may be 40 nm.

In the embodiment of the present disclosure, a passivation layer 400 is further deposited on a surface of the semiconductor device to protect the semiconductor device. The passivation layer 400 covers a surface of the barrier layer 200 (including a surface of the recess 240) away from the substrate 120 except for regions where the source 210, the drain 230, and the gate 220 are located. The passivation layer 400 includes, for example, a SiN layer with a thickness of 300 nm and a SiO₂ layer with a thickness of 600 nm.

The semiconductor device including the Sc-containing layer, such as a transistor, provided in the embodiment of the present disclosure can achieve high electron mobility and a normally-off state.

### Third Embodiment

An embodiment of the present disclosure provides a process equipment, which is a semiconductor process equipment. As shown in FIG. 10, the semiconductor process equipment includes a process chamber 500, a gas inlet assembly (not shown), an upper electrode assembly 510, a lower electrode assembly 520, and a controller (not shown). The controller includes at least one processor and at least one storage device, and the storage device has stored therein a computer program which, when executed by the processor, implements the etching method or the manufacturing method according to any one of the above embodiments.

Illustratively, the controller may be an upper computer or a lower computer. The controller may control a valve of the gas inlet assembly to be opened to introduce a corresponding process gas into the process chamber 500; and the controller may further control a degree of opening of the valve of the gas inlet assembly to control a flow rate of the process gas. The controller may further control a pumping assembly to pump the process chamber 500, so as to control a pressure in the process chamber 500 and discharge reaction by-products.

The upper electrode assembly 510 includes a radio frequency coil 511, an upper radio frequency power supply 512, and an upper matcher 513. The controller is further configured to control the upper radio frequency power supply 512 to apply an upper electrode power to the radio frequency coil 511 through the upper matcher 513, so as to enable the radio frequency coil 511 to excite the process gas in the process chamber 500 to generate plasma.

The lower electrode assembly 520 includes a wafer carrier 521, a lower radio frequency power supply 522, and a lower matcher 523. The controller is further configured to control the lower radio frequency power supply 522 to apply a lower electrode power to a lower electrode of the wafer carrier 523 through the lower matcher 523, so that the lower electrode of the wafer carrier 523 may provide a radio frequency bias to adsorb the plasma above an object to be etched (not shown) to bombard the object to be etched.

The semiconductor process equipment in the embodiment of the present disclosure may be an Inductively Coupled Plasma (ICP) etching device or a Capacitively Coupled Plasma (CCP) etching device. A type of the semiconductor processing device is not limited in the embodiment of the present disclosure.

The process equipment provided in the embodiment of the present disclosure has the beneficial effects of the etching method and the manufacturing method, and the beneficial effects will not be described here.

In the description of the present disclosure, it should be noted that the orientations or positional relationships indicated by the terms "above", "below", "front", "horizontal" and the like are the orientations or positional relationships based on the drawings, and those terms are used simply for conveniently describing the present disclosure and simplifying the description, rather than indicating or implying that the device or element referred to must have a particular orientation or must be constructed and operated in a particular orientation. Therefore, those terms should not be considered as limitation to the present disclosure.

It should be noted that in the description of the present disclosure, unless expressly stated and limited otherwise, the term "mount" should be understood broadly, for example, the term may refer to fixed connection, detachable connection, or integration; the term may refer to mechanic connection or electrical connection; and the term may refer to direct connection, indirect connection through an intermediate medium, or communication between interiors of two elements. The specific meanings of the above term in the present disclosure can be understood by those of ordinary skill in the art according to specific cases.

Finally, it should be noted that the above embodiments are just used to describe but not to limit the technical solutions of the present disclosure. Although the present disclosure is described in detail with reference to the above embodiments, it should be understood by those of ordinary skill in the art that those of ordinary skill in the art can still make modifications to the technical solutions described in the above embodiments, or make equivalent substitutions to part or all of the technical features in the above embodiments; and those modifications or substitutions do not cause the essence of the corresponding technical solutions to depart from the scope of the technical solutions of the embodiments.

## Claims

1. An etching method for a Sc-containing layer, comprising a main etching process step and an auxiliary etching process step, which are cyclically performed; wherein
the main etching process step comprises: introducing process gases into a process chamber, exciting the process gases to generate plasma, and etching the Sc-containing layer, the process gases comprising a chlorine-containing gas and an inert gas;
the auxiliary etching process step comprises: at least one of a volatilization step or a cooling step;
the volatilization step comprises: reducing a lower electrode power to zero or near zero, and decreasing flow rates of the process gases to zero or near zero; and
the cooling step comprises: reducing the lower electrode power to zero or near zero, decreasing a flow rate of the chlorine-containing gas to zero or near zero, and continuously introducing the inert gas.

2. The etching method of claim 1, wherein the main etching process step comprises a first etching step and/or a second etching step, the process gases used at the first etching step are the same as the process gases used at the second etching step, and the lower electrode power at the first etching step is higher than the lower electrode power at the second etching step.

3. The etching method of claim 2, wherein a lower electrode power ratio of the first etching step to the second etching step is 1.2:1 to 1.8:1; and/or
a process time ratio of the first etching step to the second etching step is 1:4 to 1:6.

4. The etching method of claim 3, wherein the lower electrode power at the first etching step is 100 W to 1000 W; and the lower electrode power at the second etching step is 100 W to 1000 W; and/or
a process time of the first etching step is 1.2 s to 3 s, and a process time of the second etching step is 8 s to 12 s.

5. The etching method of any one of claims 1 to 4, wherein at the main etching process step, a flow ratio of the chlorine-containing gas to the inert gas is 0.3:1 to 0.5:1; and/or
at the main etching process step, the flow rate of the chlorine-containing gas is 20 sccm to 200 sccm, and a flow rate of the inert gas is 10 sccm to 1000 sccm.

6. The etching method of claim 5, wherein the chlorine-containing gas comprises at least one of SiCl₄, BCl₃ or Cl₂, and/or the inert gas comprises Ar.

7. The etching method of claim 6, wherein the chlorine-containing gas comprises BCl₃ and Cl₂, and a flow ratio of BCl₃ to Cl₂ is 0.9:1 to 1.1:1; or
the chlorine-containing gas comprises SiCl₄.

8. The etching method of any one of claims 1 to 4, wherein a process time of the volatilization step is 0.5 s to 1.5 s; and/or a process time of the cooling step is 0.5 s to 1.5 s.

9. A manufacturing method for a semiconductor device, comprising:
providing a substrate;
forming a Sc-containing layer on the substrate;
etching the Sc-containing layer with the etching method of any one of claims 1 to 8 to form a recess with a preset depth, the preset depth being smaller than a thickness of the Sc-containing layer; and
forming a gate in the recess, and forming a source and a drain on two sides of the recess.

10. A semiconductor process equipment, comprising a process chamber, a gas inlet assembly, an upper electrode assembly, a lower electrode assembly, and a controller, wherein the controller comprises at least one processor and at least one storage device, and the at least one storage device has stored therein a computer program which, when executed by the at least one processor, implements the etching method of any one of claims 1 to 8 or the manufacturing method of claim 9.

11. A semiconductor device, comprising:
a substrate;
a Sc-containing layer, which is disposed on the substrate, a recess being formed in the Sc-containing layer on a side away from the substrate, and having a depth smaller than a thickness of the Sc-containing layer;
a source, which is disposed on a first side of the recess;
a drain, which is disposed on a second side of the recess, the second side being opposite to the first side, and a distance between the source and an edge of the recess on the first side being smaller than a distance between the drain and an edge of the recess on the second side; and
a gate, which is disposed in the recess, a distance between the gate and the source being smaller than a distance between the gate and the drain.

12. The semiconductor device of claim 11, wherein the Sc-containing layer contains ScₓAl₁₋ₓN, and a value of x is less than 43%; or
a distance between a bottom of the recess and a side of the Sc-containing layer facing the substrate is 1 nm to 100 nm; or
the distance between the source and the edge of the recess on the first side is 0.1 µm to 0.5 µm; or
the distance between the drain and the edge of the recess on the second side is 0.5 µm to 5 µm; or
a length of the gate is 0.5 µm to 5 µm, and a width of the gate is 0.1 mm to 10 mm.
